Europäisches Patentamt

European Patent Office

Office européen des brevets

(19)

(11) Publication number: **0 057 558**
**B1**

(12) **EUROPEAN PATENT SPECIFICATION**

(45) Date of publication of patent specification: **23.04.86**

(21) Application number: **82300384.3**

(22) Date of filing: **26.01.82**

(51) Int. Cl.⁴: **H 01 L 29/64,** H 01 L 21/28,
H 01 L 29/80

(54) Field effect semiconductor device and method of manufacturing such a device.

(30) Priority: **30.01.81 JP 12550/81**

(43) Date of publication of application:
**11.08.82 Bulletin 82/32**

(45) Publication of the grant of the patent:
**23.04.86 Bulletin 86/17**

(84) Designated Contracting States:
**DE FR GB**

(56) References cited:
**IEEE TRANSACTIONS ON ELECTRON
DEVICES, vol. ED-25, no. 10, October 1978,
pages 1213-1218, New York (USA); S.
TAKAHASHI et al.: "Submicrometer gate
fabrication of GaAs MESFET by plasma
etching"**
**INTERNATIONAL ELECTRON DEVICES
MEETING, Washington 1980, pages 152-154,
IEEE- New York (USA); S. INOUE et al.:
"Phosphorus doped molybdenum silicide for
LSI applications"**
**EXTENDED ABSTRACTS OF THE JOURNAL OF
THE ELECTROCHEMICAL SOCIETY, vol. 80-2,
1980, pages 854-855, Princeton (USA); F.R.
WHITE et al.: "Plasma etching of composite
silicide gate electrodes"**

(73) Proprietor: **FUJITSU LIMITED
1015, Kamikodanaka Nakahara-ku
Kawasaki-shi Kanagawa 211 (JP)**

(72) Inventor: **Fukuta, Masumi
1470, Shinkoji-cho Machida-shi
Tokyo, 194-01 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

The present invention relates to a Schottky gate field effect semiconductor device and a method of manufacturing such a device.

Higher operational speed is one of the most important requirements which field effect semiconductor devices must meet in order to be employed for circuits dealing with super high frequencies of 4 to 5 GHz or higher. Amongst the various parameters which affect the operational speed of field effect semiconductor devices carrier mobility is important, and the provision of a higher carrier (e.g. electron) mobility is a most important step towards the provision of a higher operational speed. Employment of a compound semiconductor e.g. GaAs or GaAlAs is effective to provide higher carrier mobility. This is the reason why a compound semiconductor is preferably employed for the production of field effect semiconductor devices for use in circuits dealing with super high frequencies of 4 to 5 GHz or higher.

Since it is rather difficult to produce an insulated gate on a compound semiconductor, a Schottky gate is in general employed for a field effect semiconductor device based upon a compound semiconductor. Since aluminium has a sufficiently high conductivity and a sufficient barrier height between itself and a compound semiconductor, and because it is easy to produce a fine pattern of aluminium, aluminium Schottky gates have historically been employed for field effect semiconductor devices using compound semiconductors.

However, it has been observed that corrosion of aluminium provided on a compound semiconductor can occur in humid conditions. In attempts to overcome this corrosion problem it has been discovered that a refractor metal such as W, Ti, Mo, Ta or the like, is an appropriate material for the production of a stable and reliable Schottky gate for a compound semiconductor based field effect semiconductor device. More specifically, it has been discovered that a triple layer structure of a refractory metal, platinum (Pt), and gold (Au) is useful from a practical point of view, because a lesser resistance can be achieved without there occurring any minor problem which might unavoidably arise if there were direct contact between Au and a refractory metal.

Another parameter which effects the operation speed of field effect semiconductor devices is gate length. A higher operational speed is obtained with a shorter gate length, and a shorter distance between source and drain. To provide for a shorter gate length it has been necessary to implant ions of some impurities whilst employing a Schottky gate as a mask for implantation. However, this necessity causes grave problems in practice. A Schottky contact existing between a refractory metal and a compound semiconductor is converted into an ohmic contact when it is exposed to a temperature of 600°C or higher. This means that a Schottky gate produced by depositing a refractory metal on a compound semi- conductor substrate loses the potential barrier between itself and the compound semiconductor substrate, and that there is a reduction in the inverse breakdown voltage between the Schottky gate and the compound semiconductor substrate, when the Schottky contact is exposed to a temperature of 600°C or higher for the purpose of activating the impurities implanted using the gate as a mask.

To overcome this difficulty, the use of a Schottky gate of a refractory metal alloy e.g. Ti-W has been proposed. However, the potential barrier height between a refractory metal alloy Schottky gate and a compound semiconductor substrate can be lost by exposure to a temperature of 750°C or higher. Further, a gate of this alloy material is inclined to react with GaAs and/or to be corroded during production processes, as a result suffering increased resistance. Therefore, refractory metal alloy is not necessarily a satisfactory material for production of a Schottky gate of a field effect semiconductor device using a compound semiconductor.

It has recently been proposed to produce a Schottky gate using a silicide containing one or more refractory metals e.g. W-silicide, Ti-W-silicide, Mo-silicide, Ta-silicide, et al, because such a Schottky gate can be used as a mask for an ion implantation process followed by an annealing process effected at a temperature of approximately 800°C. When such a material is employed for the production of a Schottky gate, gate length can be made approximately 1 micrometer and the distance between the source and drain can be made approximately 3 micrometers or less. These are also the minimum dimensions which can be realised at the present technical level of photolithography. A field effect semiconductor device having a high operational speed can be provided.

However, it is well-known that the provision of a shorter gate length is effective to increase the operational speed of a field effect semiconductor device. Therefore, if the length of a Schottky gate (formed using a silicide containing one or more refractory metals) could be made shorter than the minimum dimension allowed for in photolithography, it would evidently increase operational speed and allow for realisation of a field effect semiconductor device having a higher operational speed. In addition, a Schottky gate formed using a silicide of a refractory metal has a drawback in that resistance is relatively high and is of the order of $10^{-4}$ ohm-cm. If this drawback could be overcome, the operational speed of a field effect semiconductor device having a Schottky gate of a silicide of one or more refractory metals could effectively be increased.

IEEE Transactions on Electron Devices, Vol. ED—25, No. 10, October 1978, pages 1213—1218, in an article by S. Takahashi et al, entitled "Submicrometer gate fabrication of GaAs MESFET by Plasma Etching" discloses a mushroom-like submicrometer Schottky barrier gate for a GaAs MESFET which has a double-metal-layer (AU-Mo) configuration. After deposition of a photoresist pattern with a minimum dimension of 1 µm, the Au top layer is first delineated by ion milling, then the Mo bottom layer is plasma etched, to side etch the bottom layer to leave a wider top Au layer. It is stated that the width of the bottom Mo gate layer can be reduced to 0.1 µm.

Extended Abstracts of the Journal of the Electrochemical Society, Vol. 80-2, 1980, pages 854—855, Princeton (U.S.A.), in an article by F. R. White et al, entitled "Plasma etching of composite silicide gate electrodes" discloses a gate electrode with a disilicide layer ($WSi_2$) on a polysilicon layer and mentions that by plasma etching with $CF_4/O_2$ plasma the polysilicon can be etched to undercut the disilicide.

International Electron Devices Meeting, Washington 1980, pages 152—154, IEEE—New York (U.S.A.), in an article by S. Inoue et al, entitled "Phosphorous doped molybdenum silicide for LSI applications, contains a disclosure similar to White above, but pertaining to $MoSi_2$ doped with phosphorus, rather than $WS_{12}$.

According to the present invention there is provied a Schottky gate field effect semi-conductor device comprising:

a substrate of a compound semiconductor having an active region therein,

a gate electrode, on the active region, comprising silicon and at least one refractory metal,

source and drain regions in the active region, and

source and drain electrodes to the sides of the gate electrode on the active region,

the composition of the gate electrode varying through its thickness, so that, in the manufacture of the device, a portion of the gate electrode which contacts the active region has a higher etching rate than that of a portion of the gate electrode remote from the active region,

the length of the portion of the gate electrode which contacts the active region being shorter than the length of the portion of the gate electrode remote from the active region, and

edges of the source and drain electrodes and of the source and drain regions being substantially aligned with the edge of the portion of the gate electrode remote from the active region.

According to the present invention there is also provided a method of manufacturing a Schottky gate field effect semiconductor device, comprising:—

forming an active region in a compound semi-conductor substrate, and

forming a layer structure, on the active region, comprising silicon and at least one refractory metal,

the layer structure being so formed that its composition varies through its thickness to provide a portion of the layer structure which contacts the active region with a higher etching rate than that of a portion of the layer structure remote from the active region,

etching the layer structure to provide a gate electrode, wherein the length of a portion of the gate electrode which contacts the active region is shorter than the length of a portion of the gate electrode remote from the active region,

forming source and drain regions by implanting impurity into the active region employing the gate electrode as a mask,

forming an conductive layer on the active region and the gate electrode so as to form source and drain electrodes employing the gate electrode as a mask.

An embodiment of the present invention provides a field effect semiconductor device having a substrate of a compound semiconductor and a Schottky gate of one or more silicides containing one or more refractory metals, in which device Schottky gate length is reduced below the minimum dimension which can be realised by employment of photolithography. An embodiment of the present invention provides a method for production of such a device.

It will be appreciated that the term "silicide" as employed herein may designate a material having the properties of a mixture or alloy rather than the properties of a true chemical compound. The term "silicide" is, for convenience, used to designate gate materials employed in the present invention which comprise silicon and at least one refractory metal.

An embodiment of the present invention provides a field effect semiconductor device having a substrate of a compound semiconductor and a Schottky gate of one or more silicides containing one or more refractory metals, and having a Schottky gate length shorter than the minimum dimension which can be realised by employment of photolithography, in which device the resistance of the Schottky gate and of wiring connected therewith is reduced. An embodiment of the present invention provides a method for production of such a device.

A field effect semiconductor device embodying the present invention has an active region which is produced in a compound semiconductor sub-strate, of GaAs, GaAlAs or the like, a gate electrode of a layer of a compound or a mixture consisting of silicon (Si) and at least one refractory metal, or of a plurality of layers each consisting of silicon and at least one refractory metal, produced on the surface of the active region, the layer and/or the layers having the composition or compositions which varies or vary through the height or thickness of the gate electrode, so as to provide a lesser etching rate for a gate electrode portion remote from the surface of the active region than for a gate electrode portion which contacts the active region, and the length of the gate electrode portion contacting the surface of the active region being shorter than the length of the portion remote from the surface of the active region, and the device having source and drain electrodes placed on opposite sides of the gate electrode on the surface of the active region.

The variation in composition of the material of the gate electrode through the height of that electrode is effective to provide that the length of the gate electrode varies through the height thereof after a period in which the gate electrode is produced by an etching process (applied to a layer structure having a layer or layers for forming the gate electrode) because the variation in composition establishes different etching rates.

The elements Si, W, Mo, Ta and Ti have etching rates which are successively smaller element by element in the order to which the elements are listed. Therefore, a portion containing a greater quantity of Si has a faster side etching rate than a portion containing a greater quantity of one of the refractory metals, and by adjusting composition appropriately a shorter length of gate electrode can be provided for a portion contacting the surface of the active region than a portion remote from the surface of the active region. Alteration of etching conditions, e.g. alteration of concentration of etching gas et al, during an etching period can be used to enhance the differences in length of the gate electrode through the height thereof.

A variety of embodiments of the present invention can be provided.

Firstly, any of the refractory metals Ti, Ta, W, Mo or the like can be selected for use as an element of which the Schottky gate is produced, because the etching rate of Si is different from the etching rates of the refractory metals. Therefore, a gate electrode may be produced of W-silicide, Ta-silicide, Ti-silicide, Mo-silicide or the like.

However, it is essential that the composition (the amount of each element) varies through the height or thickness of the gate electrode so as to make the etching rate higher for a portion of the electrode contacting the surface of the active region than for a portion remote from the surface of the active region.

Secondly, the gate electrode can comprise a plurality of layers each consisting of Si and at least one refractory metal. In other words, the gate electrode can comprise a plurality of layers of which a lower layer consists of Si and a refractory metal having a larger etching rate (e.g. W or Mo) and of which an upper layer consists of Si and a refractory metal having a lesser etching rate (e.g. Ti or Ta).

Thirdly, the gate electrode can be produced of a material which is a compound or a mixture consisting of Si and two or more kinds of refractory metal. In this case also, the composition is selected to provide a higher etching rate for a portion contacting the surface of the active region than for a portion remote from the surface of the active region.

For example, TiW-silicide can be used as a material for the gate electrode. In this case, as described above, the W-content is larger for a portion contacting the surface of the active region and the Ti content is larger for a portion remote from the surface of the active region.

A field effect semiconductor device embodying the present invention may be provided with a layer of a metal of which the resistance is low, on the top surface of the gate electrode. Albeit the resistivity of a gate electrode of a compound or a mixture consisting of silicon and at least one refractory metal is on the order of $10^{-4}$ ohm-cm the corresponding figures for Au and Ni are $2 \times 10^{-6}$ ohm-cm and $7 \times 10^{-6}$ ohm-cm respectively. Therefore, when a Schottky gate electrode is lined with Au or Ni, resistivity decreases to a value on the order of $10^{-6}$ ohm-cm. In this case, some material, e.g. an alloy of Au and Germanium (Ge) is interleaved between the gate electrode and the Au or nickel (Ni) layer and this alloy can be used to provide ohmic contacts onto the source and drain region, which can be formed at the same time as the interleaved alloy of the gate electrode.

An embodiment of the present invention can provide a field effect semiconductor device with a high operational speed for employment for example in circuits for handling super-high frequencies of 4—5 GHz or higher. Embodiments of this invention also provide methods for production of such devices. An embodiment of the present invention can provide a field effect semiconductor device having a substrate of a compound semi-conductor (e.g. GaAs or GaAlAs) and a Schottky gate of a silicide of a refractory metal, e.g. tungsten (W), molybdenum (Mo), tantalum (Ta), titanium (Ti) or the like. In an embodiment of this invention, resistance of the refractory metal silicide Schottky gate is decreased, gate length is decreased and the distance between source and drain is decreased.

Reference is made, by way of example, to the accompanying drawings, in which:—

Figure 1 is schematic cross-sectional view of a substrate from which a field effect semiconductor device embodying the present invention is to be produced, after completion of an initial step prior to an ion implantation process for production of an n-type active region,

Figure 2 is schematic cross-sectional view of the substrate after completion of a process for production of the n-type active region,

Figure 3 is a schematic cross-sectional view of the substrate after completion of a process for production of a silicide double layer,

Figure 4 is a schematic cross-sectional view of the substrate after completion of a process for patterning the silicide double layer to provide a step-shaped Schottky gate,

Figure 5 is a schematic cross-sectional view of the substrate after completion of a process for production of a field insulating film,

Figure 6 is a schematic cross-sectional view of the substrate after completion of an ion implantation process for production of $n^+$-type source and drain regions,

Figure 7 is a schematic cross-sectional view of the substrate after completion of a process for production of Au-Ge alloy and Ni layers on the step-shaped silicide double layer and on the source and drain regions, and

Figure 8 is a schematic cross-sectional view of the substrate after completion of a process for plating Au layers on source and drain electrodes.

Described below are the main steps in the production of a field effect semiconductor device embodying the present invention having an n-type active, or channel, region produced in a semi-insulating GaAs substrate, a gate electrode of Ti-W-silicide, in which the W-content is larger for a portion contacting the surface of the n-type active region than for a portion remote from the surface of the n-type active region, and of which the length is smaller for the portion contacting the surface of the n-type active region than for the portion remote from the surface of the n-type active region, and source and drain electrodes each of Au-Ge and Ni double layer structure.

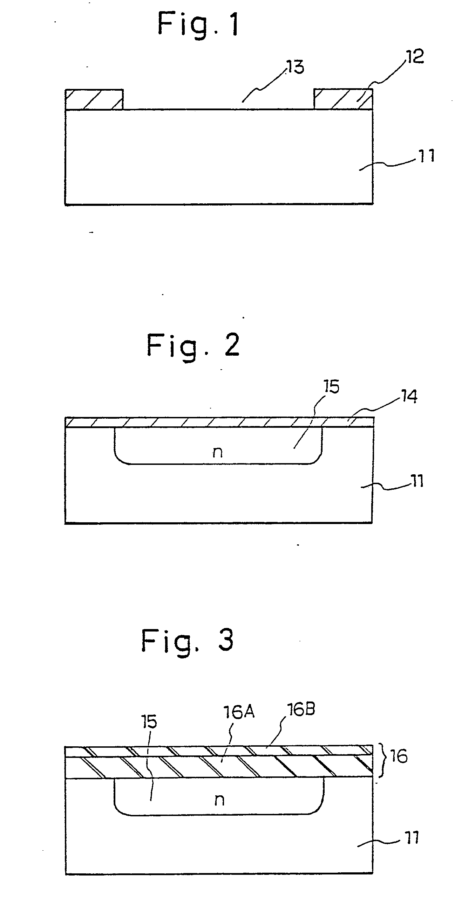

Referring to Figure 1, a sputtering process is employed to cover the surface of a chromium (Cr)-doped semi-insulating GaAs substrate 11 with a silicon dioxide ($SiO_2$) film 12 having a thickness of approximately 6000 Å, before a photolithography process is employed to remove a part of the silicon dioxide film 12 selectively from an area in which a field effect semiconductor device is to be produced. As a result, a window 13 is produced in the selected area on the substrate 11. The part of the silicon dioxide film 12 remaining on the substrate 11 acts as a mask for an ion implantation process carried out for the purpose of introducing silicon (Si) ions into the region of the substrate 11 defined by window (13) for the ultimate purpose of producing a n-type active region. Ion implantation energy and dose are 175 KeV and $2.6 \times 10^{12}/cm^2$ repectively.

Referring to Figure 2, after the remaining part of the silicon dioxide film 12 has been removed by means of a chemical etching process, a sputtering process is employed to cover the surface of the substrate 11 with a silicon dioxide ($SiO_2$) film 14 having a thickness of 1000 Å. An annealing process is applied to the substrate for 15 minutes in $N_2$ gas at a temperature of 850°C to activate the implanted silicon ions. The silicon dioxide film 14 acts as a protection film during this annealing process. As a result, the production of a n-type active region 15 is completed.

The n-type active region 15 may alternatively be formed by an epitaxial growth method on the semi-insulating GaAs substrate 11, instead of using selective ion implantation as described above.

Referring to Figure 3, a double silicide layer 16 having a total thickness of 1 micrometer is produced on the surface of the substrate 11, after the silicon dioxide film 14 is removed by means of a chemical etching process in the illustrated embodiment of the invention, the double silicide layer 16 consists of a lower layer 16A of $Ti_{0.3}W_{0.7}Si_2$ having a thickness of 7000 Å and an upper layer 16B of $Ti_{0.8}W_{0.2}Si_2$ having a thickness of 3000 Å. In other words, the lower layer 16A contains a higher quantity of W and the upper layer 16B contains a higher quantity of Ti.

As an alternative to the illustrated double layer, a triple layer can be used.

As an alternative to an abrupt change or abrupt changes of layer composition, a gradual change or gradual changes of composition can be employed.

The double silicide layer 16 can be produced by means of sputtering processes as described below. For example, three sputtering targets of Ti, W and Si are placed in a sputtering chamber, and each of the three sputtering targets is provided with a shutter for control of the quantity of the material of the target to be sputtered.

Alternatively, at least two sputtering targets, each of which has a different composition, are placed in a sputtering chamber. Each of the at least two sputtering targets is accompanied by an Si target and is provided with a shutter for switching the sputtering target and the accompanying Si target.

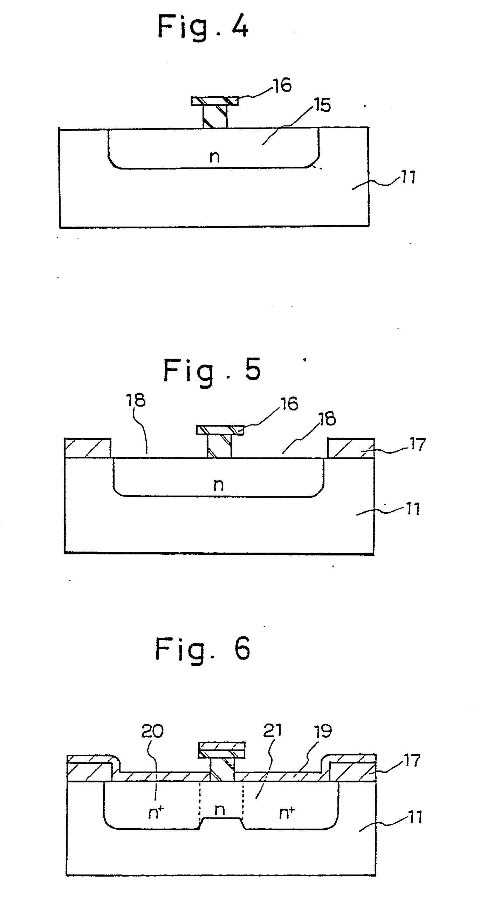

Referring to Figure 4, a photolithgraphy process and a dry etching process are, in combination, employed for patterning the double silicide layer 16 to shape a Schottky gate electrode. A comingled gas containing 95% $CF_4$ and 5% $O_2$ can be employed as an etching gas in the case of the illustrated embodiment. Since etching rate is larger for W than for Ti, (although a common etchant is used) the lower layer 16A is etched more than the upper layer 16B, as a result producing a stepped shape or T-shape as shown in Figure 4. This means that a length can be provided for a gate which is less than the minimum dimension which can be realised by employment of photolithography.

If, as an alternative to the abrupt composition change of the layer 16 of Figure 4, in a silicide layer 16 the ratio of W to Ti gradually decreases so that the proportion of Ti increases as height above the active region increases, a Schottky gate having inclined sides can be produced.

As described above, the material for production of a Schottky gate electrode of a field effect semiconductor device can alternatively be a binary silicide such as W-silicide, Ti-silicide or the like. In such a case, the Si content (the proportion of Si) is reduced as distance from the n-type active region increases, so that a portion remote from the n-type active region has less Si than a portion contacting the n-type active region.

Referring to Figure 5, silicon dioxide ($SiO_2$) film 17 having a thickness of 6000 Å is plated on the surface of substrate 11, whereafter the silicon dioxide film 17 is removed from the surface of the n-type active region 15 and from a surrounding area, to produce a window 18, leaving the silicon dioxide film 17 on the field area of the device.

The area of the window 18 is larger than that of the n-type active region so that gate width can be secured regardless of unavoidable displacements due to errors in mask positioning.

Referring to Figure 6, a n-type impurity, e.g. Si, is implanted into the n-type active region 15 and into the semi-insulating substrate 11 employing the silicon dioxide film 17 and the step-shaped silicide double layer 16 as a mask. Energy and dose of this implantation are 175 KeV and

$1.7 \times 10^{13}/cm^2$ respectively. Thereafter the surface of the wafer is covered with a silicon dioxide (SiO$_2$) film 19 and an annealing process is applied to the substrate for 15 minutes in N$_2$ gas at a temperature of 800°C for activating the implanted n-type impurity, converting portions of the n-type active region 15 into n$^+$-type regions 20 and 21. The silicon dioxide film 19 acts as a protection film during the annealing process. A source electrode and a drain electrode are plated on the n$^+$-type regions 20 and 21 respectively as described below.

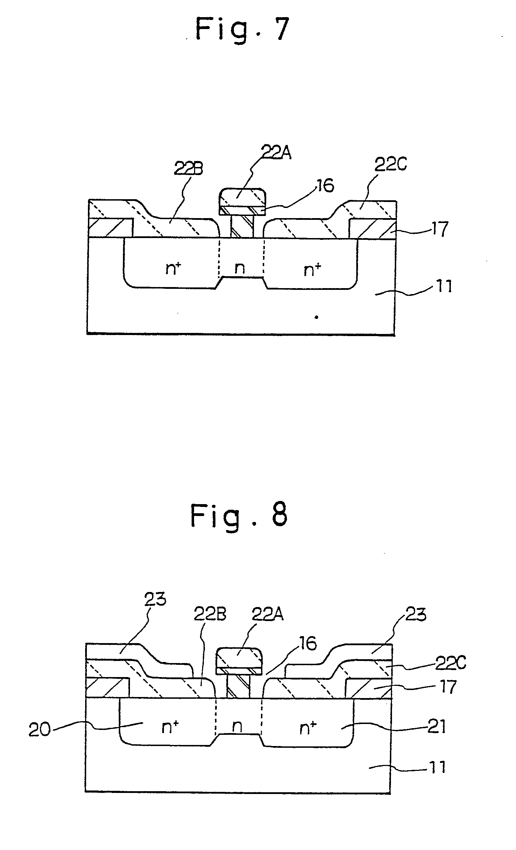

Referring to Figure 7, the silicon dioxide film 19 is entirely removed, before metal films 22A, 22B and 22C are produced respectively on the step-shaped silicide double layer 16 and the n$^+$-type regions 20 and 21. Each of the metal films 22A, 22B and 22C is of a double layer structure comprising a Au-Ge alloy layer approximately 1500 Å thick and a Ni layer approximately 200 Å thick, which latter layer is evaporated onto the Au-Ge alloy layer. Since the height of the step-shaped silicide double layer of Schottky gate electrode 16 is larger than the thickness of the Au-Ge alloy and Ni layers 22B and 22C, the Au-Ge alloy and Ni layers 22A are separated from the other layers 22B and 22C, as shown in Figure 7. Since the gate electrode consists of the Au-Ge alloy and Ni layers and the silicide double layer 16, its resistivity is decreased so that it approaches that of Au, e.g. a few times $10^{-6}$ ohm-cm. This represents a reduction in resistivity to a few hundredths of that obtained using only silicides of refractory metals. The Au-Ge alloy and Ni layers 22B and 22C provide source and drain electrodes or wiring.

Referring to Figure 8, plating of Au layers 23 having a thickness of 1 micrometer on the source and drain electrodes of Au-Ge alloy and Ni layers is effective to substantially decrease the resistance of the source and drain electrodes or wiring.

The gate length of the illustrated GaAs based field effect semiconductor device embodying the present invention, that is, the horizontal dimension of the foot of the step-shaped or T-shaped silicide double layer 16 can be made less than the minimum dimension which can be realised by photolithography. Therefore, the horizontal dimension of the step-shaped silicide double layer 16 can be made less than 1 micrometer at that part thereof contacting the surface of the n-type active region, albeit the horizontal dimension of the double layer 16 is approximately 1 micrometer at that part thereof most remote from the surface of the n-type active region.

In addition, since the gate electrode has a layer structure comprising an Ni layer, a Au-Ge alloy layer and a silicide layer, the resistance thereof can be reduced to considerably less than that of a metal silicide layer. The resistance of the gate and source electrodes having an Ni layer and a Au-Ge layer structure can also be reduced. As a result, the illustrated GaAs based field effect semiconductor device embodying the present invention can provide higher operational speeds and can be employed in a circuit which deals with super high frequencies.

In a method of production of a field effect semiconductor device embodying the present invention, the source region 20, the drain region 21, the source electrode 22B and the drain electrode 22C as described above can be produced employing a self-alignment method using the gate electrode as a mask. Therefore, in accordance with this method, a GaAs field effect semiconductor device having finer patterns can be produced by a simpler process.

The gate electrode 16 can have a double layer structure and, alternatively a triple layer structure or a structure in which a layer composition gradually changes. Further, the material of the gate electrode can not only be a ternary compound or mixture but alternatively a binary compound or mixture containing Si and one refractory metal. In each case, composition must be such that etching rate is less in a portion more remote from the n-type active region than in a portion contacting the n-type active region.

The material of the gate electrode can be a silicide comprising any of the refractory metals, such as W, Ti, Mo, Ta, et al.

The material of the field insulating film can be either SiO$_2$, or Si$_3$N$_4$, or Al$_2$O$_3$ or the like.

Needless to say, a plurality of field effect semiconductor devices embodying the present invention can be produced on one substrate or wafer.

An embodiment of the present invention provides a field effect semiconductor device having a substrate of a compound semiconductor (e.g. GaAs, GaAlAs or the like) having a conduction channel or active region, and a gate electrode of one or more silicides of one or more refractory metals varying in composition or compositions through the height of the gate electrode so that the etching rate thereof varies through the height of the gate electrode, and so that a portion of the gate electrode contacting the active region is shorter than a portion thereof remote from the active region. The gate electrode is preferably lined with a metal having a large conductivity. Source and drain electrodes are produced on the active region. The field effect semiconductor device can have a high operational speed so as to be appropriate for super high frequency circuits.

A field effect semiconductor device embodying the present invention comprises, for example, a substrate of a compound semi-conductor, said substrate having an active region, a gate electrode consisting of silicon and at least one refractory metal placed on the surface of the active region, the gate electrode having a length which is shorter for the portion contacting with the surface of the active region than for the portion remove from the surface of the active region, and source and drain electrodes placed on both sides across the gate electrode, on the surface of the active region.

## Claims

1. A Schottky gate field effect semiconductor device comprising:—

a substrate of a compound semiconductor having an active region therein,

a gate electrode, on the active region, comprising silicon and at least one refractory metal,

source and drain regions in the active region, and

source and drain electrodes to the sides of the gate electrode on the active region,

the composition of the gate electrode (16) varying through its thickness so that, in the manufacture of the device, a portion of the gate electrode which contacts the active region (15) has a higher etching rate than that of a portion of the gate electrode remote from the active region,

the length of the portion of the gate electrode (16) which contacts the active region being shorter than the length of the portion of the gate electrode remote from the active region, and

edges of the source and drain electrodes (22B, 22C) and of the source (20) and drain (21) regions being substantially aligned with the edge of the portion of the gate electrode remote from the active region.

2. A device as claimed in claim 1, wherein the gate electrode comprises a layer constituted of silicon and at least one refractory metal, the proportions in which those substances are present in the layer gradually varying through the thickness of the layer.

3. A device as claimed in claim 1, wherein the gate electrode comprises a plurality of layers each constituted of silicon and at least one refractory metal, different layers having a respective different compositions.

4. A device as claimed in any preceding claim, wherein the said at least one refractory metal is W or Ti or Mo or Ta.

5. A device as claimed in any preceding claim, wherein the gate electrode is covered by a material of high conductivity, for example AU-Ge alloy.

6. Method of manufacturing a Schottky gate field effect semiconductor device, comprising:—

forming an active region in a compound semiconductor substrate, and

forming a layer structure, on the active region, comprising silicon and at least one refractory metal, the layer structure (16) being so formed that its composition (16A, 16B) varies through its thickness to provide a portion of the layer structure which contacts the active region (15) with a higher etching rate than that of a portion of the layer structure remote from the active region,

etching the layer structure to provide a gate electrode, wherein the length of a portion of the gate electrode which contacts the active region (15) is shorter than the length of a portion of the gate electrode remote from the active region,

forming source (20) and drain (21) regions by implanting impurity into the active region employing the gate electrode as a mask,

forming a conductive layer (22) on the active region and the gate electrode so as to form source (22B) and drain (22C) electrodes employing the gate electrode as a mask.

7. A method as claimed in claim 6, wherein the layer structure is so formed as to comprise a layer constituted of silicon and at least one refractory metal, the proportions in which those substances are present in the layer gradually varying throught the thickness of the layer.

8. A method as claimed in claim 6, wherein the layer structure is so formed as to comprise a plurality of layers each constituted of silicon and at least one refractory metal, different layers having a respective different compositions.

## Patentansprüche

1. Feldeffekt-Halbleitervorrichtung mit Schottky-Gate, mit:

einem Substrat aus einem Verbindungshalbleiter mit einem aktiven Bereich in diesem,

einer Gateelektrode, auf dem aktiven Bereich, die Silizium und wenigstens es ein hintzebeständigen Metall umfaßt,

Source-und Drainbereichen im aktiven Bereich und

Source-und Drainelektroden an den Seiten der Gateelektrode auf dem aktiven Bereich,

bei welcher die Zusammensetzung der Gateelektrode (16) über ihre Dicke so variiert, daß bei der Herstellung der Vorrichtung ein Teil der Gateelektrode, welcher den aktiven Bereichen (15) kontaktiert, eine Ätzrate hat, die höher als diejenige eines Abschnitts der Gateelektrode ist, welcher von dem aktiven Bereich entfernt ist,

die Länge des Abschnitts der Gateelektrode (16), welcher den aktiven Bereich kontaktiert, kürzer als die Länge des Abschnitts der Gateelektrode ist, der von dem aktiven Bereich entfernt ist, und

Ränger der Source- und Drainelektroden (22B, 22C) und der Source (20) und Drainbereiche (21) im wesentlichen mit dem Rand des Abschnitts der Gatelektrode der von dem aktiven Bereich entfernt ist, ausgerichtet sind.

2. Vorrichtung nach Anspruch 1, bei welchem die Gatelektrode eine Schicht umfaßt, die aus Silizium und wenigstens einem hitzebeständigen Material besteht, bei welcher die Proportionen, in denen die Substanzen in der Schicht vorhanden sind, graduierlich durch die Dicke der Schicht variieren.

3. Vorrichtung nach Anspruch 1, bei welcher die Gateelektrode eine Vielzahl von Schichten umfaßt, von denen jede aus Silizium und wenigstens einem hitzebeständigen Metall besteht, wobei verschiedene Schichten jeweils verschiedene Zusammensetzungen aufweisen.

4. Vorrichtung nach einem der vorhergehenden Ansprüche, bei welchem des genannte wenigstens eine hitzebeständiges Metall W oder Ti oder Mo oder Ta ist.

5. Vorrichtung nach einem der vorhergehenden Ansprüche, bei welcher die Gateelektrode durch ein Material hoher Leitfähigkeit, z.B. durch ein Au-Ge-Legierung, dedeckt ist.

6. Verfahren zur Herstellung einer Feldeffekt-Halbleitervorrichtung mit Schottky-Gate, mit

Bildung eines aktiven Bereichs in einem Verbindungshalbleitersubstrat, und

Bildung einer Schichtstruktur, auf dem aktiven Bereich, die Silizium und wenigstens ein hitzebeständiges Metall umfaßt,

bei welchem die Schichtstruktur (16) so gebildet ist, daß ihre Zusammensetzung (16A, 16B) über ihre Dicke variiert, um in der Schichtstruktur einen Abschnitt, welcher den aktiven Bereich (15) kontaktiert, mit einer höheren Ätzrate als derjenigen eines Abschnitts der Schichtstruktur zu bilden, welcher von dem aktiven Bereich entfernt ist,

die Schichtstruktur geätzt wird, um eine Gateelektrode zu bilden, bei welcher die Länge eines Abschnitts der Gateelektrode, welcher den aktiven Bereich (15) kontaktiert, kürzer ist als die Länge eines Abschnitts der Gateelektrode, welcher von dem aktiven Bereich entfernt ist,

Source (20) und Drainbereiche (21) durch Implantieren einer Verunreinigung in den aktiven Bereich unter Verwendung der Gateelektrode als Maske gebildet werden,

eine leitende Schicht (22) auf dem aktiven Bereich und der Gateelektrode gebildet wird, um Source- (22B) und Drainelektroden (22C) zu bilden, wobei die Gateelektrode eine Maske verwendet wird.

7. Verfahren nach Anspruch 6, bwi welchem die Schichtstruktur so gebildet ist, daß sie eine Schicht umfaßt, daß sie aus Silizium und wenigstens einem hitzebeständigen Metall besteht, und die Proportionen, in denen diese Substanzen in der Schicht vorliegen, über die Dicke der Schicht graduierlich variieren.

8. Verfahren nach Anspruch 6, bei welchem die Schichtstruktur so gebildet ist, daß sie eine Vielzahl vmn Schichten umfaßt, die jeweils aus Silizium und wenigstens einem hitzebeständigen Metall bestehen, wobei verschiedene Schichten entsprechend jeweils Zusammensetzungen haben.

**Revendications**

1. Dispositif semiconducteur à effet de champ à grille Schottky comprenant:

un substrat en un semiconducteur composé ayant une région active,

une électrode de grille sur la région active comprenant du silicium et au moins un métal réfractaire,

des régions de source et de drain dans la région active, et

des électrodes de source et de drain sur les côtés de l'électrode de grille sur la région active,

la composition de l'électrode de grille (16) variant selon son épaisseur de sorte que, au cours de la fabrication du dispositif, une partie de l'électrode de grille qui est en contact avec la région active (15) a une vitesse d'attaque plus élevée que celle d'une partie de l'électrode de grille éloignée de la région active,

la longueur de la partie de l'électrode de grille (16) en contact avec la région active étant plus courte que la longueur de la partie de l'électrode de grille éloignée de la région active, et

les bors des électrodes de source et de drain (22B, 22C) et des régions de source (20) et de drain (21) étant sensiblement alignés avec le bord de la partie de l'électrode de grille éloignée de la région active.

2. Dispositif selon la revendication 1, caractérisé en ce que l'électrode de grille comprend une couche constituée de silicium et d'au moins un métal réfractaire, les proportions dans lesquels ces substances sont présentes dans la couche variant progressivement selon l'épaisseur de la couche.

3. Dispositif selon la revendication 1, caractérisé en ce que l'électrode de grille comprend plusieurs couches constituées chacune de silicium et d'au moins un métal réfractaire, des couches différentes ayant des compositions repsectives différentes.

4. Dispositif selon l'une quelconque des revendications précédentes, caractérisé en ce que ledit au moins un métal réfractaire est W ou Ti ou Mo ou Ta.

5. Dispositif selon l'une quelconque des revendications précédentes, caractérisé en ce que l'électrode de grille est recouverte d'un matériau à haute conductivité, par exemple un alliage Au-Ge.

6. Procédé de fabrication d'un dispositif semiconducteur à effet de champ à grille Schottky comprenant les étapes suivantes:

former une région active dans un substrat semiconducteur composé, et

former une structure de couche, sur la région active, comprenant du silicium et au moins un métal réfractaire, la structure de couche (16) étant formée de sorte que sa composition (16A, 16B) varie selon son épaisseur pour conférer à une partie de la structure de couche en contact avec la région active (15) une vitesse d'attaque plus élevée que celle d'une partie de la structure de couche éloignée de la région active,

attaquer la structure de couche pour fournir une électrode de grille, dans laquelle la longueur d'une partie de l'électrode de grille en contact avec la région active (15) est plus courte que la longueur d'une partie de l'électrode de grille éloignée de la région active,

former les régions de source (20) et de drain (21) par implantation d'une impureté dans la région active en utilisant l'électrode de grille comme masque,

former une couche conductrice (22) sur la région active et l'électrode de grille pour former des électrodes de source (22B) et de drain (22C) en utilisant l'électrode de grille comme masque.

7. Procédé selon la revendication 6, caractérisé

15 0 057 558 16

en ce que la structure de couche est formée de façon à comprendre une couche constituée de silicium et d'au moins un métal réfractaire, les proportions dans lesquelles ces substances sont présentes dans la couche variant progressivement selon l'épaisseur de la couche.

8. Procédé selon la revendication 6, caractérisé en ce que la structure de couche est formée de façon à comprendre plusieurs couches constituées chacune de silicium et d'au moins un métal réfractaire, différentes couches ayant des compositions respectives différentes.

9

# Fig. 1

# Fig. 2

# Fig. 3

# Fig. 4

# Fig. 5

# Fig. 6

# Fig. 7

# Fig. 8